(19) Europäisches Patentamt
European Patent Office
Office européen des brevets

(11) **EP 4 484 992 A1**

(12) **EUROPEAN PATENT APPLICATION**

(43) Date of publication:
**01.01.2025 Bulletin 2025/01**

(21) Application number: **23182026.7**

(22) Date of filing: **28.06.2023**

(51) International Patent Classification (IPC):
***G01R 33/48*** (2006.01)    ***G01R 33/561*** (2006.01)
***G01R 33/565*** (2006.01)

(52) Cooperative Patent Classification (CPC):
**G01R 33/56509; G01R 33/4818; G01R 33/5611**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
- **Siemens Healthineers AG**
  **91301 Forchheim (DE)**
- **The General Hospital Corporation**
  **Boston, MA 02114 (US)**

(72) Inventors:
- **Polak, Daniel**
  **91052 Erlangen (DE)**
- **Cauley, Stephen Farman**
  **Winchester, 01890 (US)**
- **Feiweier, Thorsten**
  **91099 Poxdorf (DE)**
- **Splitthoff, Daniel Nicolas**
  **91080 Uttenreuth (DE)**
- **Wald, Lawrence L.**
  **Cambridge, MA, 02138 (US)**

(74) Representative: **Siemens Healthineers Patent Attorneys et al**
  **Postfach 22 16 34**
  **80506 München (DE)**

(54) **A METHOD FOR ACQUIRING A MAGNETIC RESONANCE IMAGE DATASET**

(57)    The invention relates to a method for acquiring a magnetic resonance image dataset of a field-of-view using an imaging protocol, wherein the method comprises acquiring a low-resolution scout image dataset (25, 52) of the field-of-view, and
sets of one or several additional k-space lines (30) within a central region (16) of k-space at regular intervals during the imaging protocol. The contrast of the low-resolution scout image dataset (25) and the contrast of the additional k-space lines (30) are matched and are independent of the contrast of the magnetic resonance image dataset. For example, the low-resolution scout image dataset (25) and the additional k-space lines (30) are acquired after an at least approximately matched magnetization preparation (60) and matched recovery times.

FIG 5

## Description

The invention relates to a method for acquiring a magnetic resonance image dataset, to a magnetic resonance imaging apparatus and to a computer program.

Independent of the grammatical term usage, individuals with male, female or other gender identities are included within the term.

Patient motion is one of the most common and costly of artefacts in Magnetic Resonance Imaging (MRI) and can seriously degrade the diagnostic quality of magnetic resonance (MR) exams.

Fast imaging protocols reduce the impact of motion. For example, parallel imaging techniques, as summarised in J. Hamilton, D. Franson, and N. Seiberlich "Recent Advances in Parallel Imaging for MRI," Prog. Nucl. Magn. Reson. Spectrosc., vol. 101, pp. 71-95, 2017, exploit the properties of modern multi-channel coil arrays to separate aliased pixels in the image domain or to estimate missing k-space data, using knowledge of nearby acquired k-space points, in order to allow scan time reduction by sampling a smaller number of phase encoding lines in k-space.

Some magnetic resonance imaging (MRI) motion correction techniques involve measuring the motion by tracking devices or navigator acquisitions.

By contrast, retrospective methods correct for motion artefacts after the data acquisition without disruptions to the sequence timing or inclusion of additional hardware. By including motion parameters into the MR forward model, these techniques account for the patient's motion in the final image reconstruction and therefore reduce motion artefacts. In some techniques, the motion data can be derived from the acquired k-space data itself. For multi-shot acquisitions, the goal in retrospective motion correction techniques is to extract the *per shot* motion parameters and the motion-free image simultaneously. This can be accomplished by either minimizing an image quality metric, such as image entropy, or by minimizing the data consistency error of a parallel "imaging + motion" forward model, as described in L. Cordero-Grande, E. J. Hughes, J. Hutter, A. N. Price, and J. V Hajnal, "Three-dimensional motion corrected sensitivity encoding reconstruction for multi-shot multi-slice MRI: Application to neonatal brain imaging," Magn. Reson. Med., vol. 79, no. 3, pp. 1365-1376, 2018, L. Cordero-Grande, R. Teixeira, E. Hughes, J. Hutter, A. Price, Hajnal, "Sensitivity Encoding for Aligned Multishot Magnetic Resonance Reconstruction," IEEE Trans. Comput. Imaging, vol. 2, no. 3, pp. 266-280, 2016 and M. W. Haskell, S. F. Cauley, and L. L. Wald, "TArgeted Motion Estimation and Reduction (TAMER): Data consistency based motion mitigation for MRI using a reduced model joint optimization," IEEE Trans. Med. Imaging, vol. 37, no. 5, pp. 1253-1265, 2018. For the latter, the motion and image vector are jointly estimated via an inversion of the non-linear forward model. This corresponds to a large-scale non-linear optimization problem that is typically computationally very expensive. Previously proposed methods alternate between optimizing just the image or the motion parameters while assuming the other to be fixed (see L. Cordero-Grande in Magn. Reson. Med.), instead of updating all optimization variables at once. Nevertheless, repeated updates of the imaging voxels lead to excessive computation that prohibits its use in clinical settings.

When the "imaging + motion" model and the underlying imaging protocol also include parallel imaging techniques which make use of the complex sensitivity profiles of multi-channel coil arrays, such as SENSE (SENSitivity Encoding) or ASSET (Array coil Spatial Sensitivity Encoding), it is referred to as "SENSE + motion" model.

In "Scout accelerated motion estimation and reduction (SAMER)", Magn. Reson. Med., vol. 87, pp. 163-178, 2022, https://doi.org/10.1002/mrm.28971, D. Polak, D. N. Splitthoff, B. Clifford, W.-C. Lo, S. Huang, J. Conklin, L. L. Wald, K. Setsompop and S. Cauley propose a technique that utilizes a single rapid scout scan to drastically reduce the computational cost of motion estimation. The scout image contains centre of k-space information which is compared against the k-space data of the actual MR acquisition for each shot, to derive the subject's motion. This corresponds to registration of the k-space data with the scout image in k-space. This strategy is used to completely avoid the alternating optimization of subject motion and image volume, which is otherwise required in retrospective motion correction techniques. In the SAMER-technique, a motion trajectory of the subject is first estimated, and the motion trajectory is then used in a motion-aware parallel image reconstruction, using e.g. a "SENSE + motion" forward model, to yield the motion-mitigated image. This reduces the computational costs by several orders of magnitude, when compared to established alternating optimization methods.

In D. Polak, J. Hossbach, D. N. Splitthoff et al. "Motion guidance lines for robust data consistency-based retrospective motion correction in 2D and 3D MRI", Magn. Reson. Med. 2023:1-14, doi: 10.1002/mrm.29534, D. Polak et al. have extended the SAMER method to include the repeated acquisition of a small number of motion guidance lines in each shot, which are used for motion estimation by being compared with the data from the scout scan. This allows for very rapid and fully separable estimation of motion parameters shot-by-shot.

However, the SAMER method using additional motion guidance lines has some disadvantages which make it not equally well suitable to all types of imaging protocols. For example, the method requires the low-resolution scout scan to be acquired very rapidly, so that it can be assumed to be motion-free. In a three-dimensional (3D) imaging sequence, this can be achieved using a single shot of data acquisition, having for example a scan time of about 1 sec in a 3D MPRAGE (Magnetisation Prepared Rapid Acquisition with Gradient Echoes) sequence. In a two-dimensional (2D) scan, in which a stack of 2D images (also referred to as "slices") is acquired in one imaging protocol, the acquisition time for the corresponding 2D low-resolution scout image dataset comprising a stack of 2D images can be much longer: While a single slice of the 2D scout may be acquired in just a single echo train, i.e. in about 100-200 msec, a full stack of N slices (N=20-30) will take several seconds (e.g., 6 seconds in T2 TSE (Turbo Spin-Echo). Hence, the scout scan can no longer be considered motion-free, which is a pre-requisite for SAMER. This problem is even worse in sequences using concatenations such as T2 FLAIR TSE (FLuid Attenuated Inversion Recovery), in which e. g. all of k-space from odd slice numbers is acquired in the first half of the scan, while even slice numbers are sampled in the second half, or the other way round. As the scout slices are always acquired in the first echo train of each concatenation, the acquisition of odd and even scout slices are now separated by up to 1-2 minutes. This dramatically increases the risk of motion in the scout data.

It is therefore an object of the present invention to overcome these problems of the SAMER method, in particular the problem of long acquisition times of the low-resolution scout scan. It is a further object of the invention to provide a method for acquiring MR image datasets for retrospective motion correction, which can be applied to all types of imaging protocols, independent of their contrast and type (e.g. gradient echo, spin echo, inversion recovery etc.).

These objects are met by a method for acquiring a magnetic resonance image dataset of a field-of-view, using an imaging protocol in which spatial encoding is performed using phase encoding gradients along at least one phase encoding direction, and frequency encoding gradients along a frequency encoding direction, wherein k-space is sampled during the imaging protocol in a plurality of k-space lines oriented along the frequency encoding direction, and having different positions in the at least one phase encoding direction. The method comprises acquiring a low-resolution scout image dataset of the field-of-view. The method also comprises acquiring sets of one or several additional k-space lines within a central region of k-space at - at least approximately - regular intervals during the imaging protocol. The method is characterised in that the contrast of the low-resolution scout image dataset and the contrast of the additional k-space lines are at least approximately matched and are in particular independent of the contrast of the magnetic resonance image dataset. In some embodiments, the contrast of the low-resolution scout image dataset and the contrast of the additional k-space lines are different to the contrast of the magnetic resonance image dataset.

The invention has recognized that some amendments are required to the method proposed by D. Polak in Magn. Reson. Med. 2023:1-14, doi: 10.1002/mrm.29534, in order for the method to be broadly applicable to different types of imaging protocols and protocol settings. In particular, the retrospective motion correction using a small number of additional k-space lines, which are herein also referred to as "motion guidance lines" or "guidance lines", is greatly facilitated if the contrast of the low-resolution scout image dataset (hereinafter also referred to as "scout" or "scout image") has a similar or preferably the same contrast as the motion guidance lines. "Contrast" in the context of this application may mean the contrast imparted on the MR data by the specific acquisition timing, e.g. TR (repetition time), TE (echo time) or TI (Inversion Time), as well as any magnetization preparation and other factors which influence which types of tissues appear dark and which appear bright in the MR image dataset. The invention has recognised that, in order to be able to use only a few motion guidance lines to estimate motion parameters of the subject and thereby reconstruct a motion-corrected image dataset, it is necessary that the additional k-space lines and the scout image have at least similar contrast. Therefore, the invention proposes to match the contrast of the low-resolution scout image dataset and the contrast of the additional k-space lines. This can be achieved by designing the acquisition of the scout and/or the motion guidance lines such that their contrast is at least approximately equal, independent of the desired contrast of the imaging protocol used for the acquisition of the motion-corrected image dataset. For example, the contrast of the scout image can be adapted to match the contrast of the motion guidance lines, or vice versa. "At least approximately matched" may mean that the contrast is matched to within $\pm 15\%$, preferably to within $\pm 10\%$, most preferred to within $\pm 5\%$.

In useful embodiments, the additional k-space lines are no longer fully integrated into the imaging protocol, for example into an echo train, but are present as a separate entity. Thereby, the same acquisition module (i.e. the steps of the inventive method concerning the acquisition of the scout image and the additional k-space lines) can be used for different types of imaging sequences, for example for spin-echo (SE), turbo spin-echo (TSE), gradient echo, or inversion recovery (IR) sequences with different contrasts, such as T1-weighted, T2-weighted, spin-density, FLAIR etc., and independent of the sequence settings, such as resolution, bandwidth, echo time (TE) etc. In preferred embodiments, the type of imaging sequence and the sequence settings used for the scout image and the motion guidance lines are selected independently from the type of imaging sequence used for the acquisition of the image dataset, i.e. in the imaging protocol. In many useful embodiments, the type of imaging sequence and/or the sequence settings used for the scout image and the motion guidance lines are different to those used for the acquisition of the image dataset. For example, if the imaging sequence used in the imaging protocol is a spin echo sequence, the scout image and the motion guidance lines can be acquired using a gradient echo type sequence. Preferably, the scout image and the motion guidance lines are acquired using the same type of imaging sequence and similar or identical sequence settings. Thus, the acquisition of the image dataset on the one hand, and the acquisition of the scout image and the guidance lines on the other hand, are completely decoupled, in the sense that they can have different contrasts and use different sequence timings. This makes the inventive approach very flexible and easy to integrate into different types of image protocols.

In addition, the invention has minimal impact on the image quality and contrast, which leads to minimal disruption of the sequence timing of the imaging protocol, and can be simply integrated into any type of imaging protocol/sequence. It also leads to minimal increases in RF (radiofrequency) stimulation and SAR (Specific Absorption Rate).

The inventive method may be executed on any medical or other MRI apparatus. The field-of-view includes a body part of a subject, which may be human or animal, in particular a patient to be examined. The image dataset is in particular acquired from a part of the body that is subject to undesired motion, for example the head or neck, a limb such as a leg, arm, knee, hand, or a part subjected to breathing motion such as the thorax or abdomen. The image dataset may be a 3D dataset, acquired using two phase encoding directions, or it may be a 2D image dataset, wherein a 2D image dataset comprises one or preferably a stack of 2D slices. A 2D image dataset is acquired using a slice selection gradient typically followed be phase encoding in one in-plane direction and frequency encoding in the other in-plane direction.

The imaging protocol may use any type of imaging sequence, for example a spin-echo or gradient echo sequence. The method of the invention is particularly suited to TSE or TSE-type sequences, for example having T1-weighted, T2-weighted or other contrast. It may be a non-steady-state sequence, i. e. one in which the signal intensity or contrast varies over an echo train in particular due to T1 and/or T2 relaxation, such as MPRAGE (Magnetization Prepared Rapid Gradient Echo Imaging) or TSE. It may also be an imaging protocol in which two images are acquired shortly one after the other after the same preparation pulse with different contrasts, such as MP2RAGE. Further examples of the imaging protocol are a SPACE sequence (Sampling Perfection with Application optimized Contrast using different flip angle Evolution) and FLAIR (Fluid-attenuated inversion recovery) sequence, but other types of imaging sequences are also possible.

The thereby acquired magnetic resonance image dataset, also referred to as "image dataset", "image" or "high-resolution image", is designed to be reconstructed using retrospective motion correction techniques, in particular the technique disclosed by D. Polak et al. in Magn. Reson. Med., vol. 87, pp. 163-178, 2022 and Magn. Reson. Med. 2023:1-14, doi: 10.1002/mrm.29534. The image dataset is typically acquired for diagnostic purposes and thus preferably has a high spatial resolution of, for example, an in-plane resolution of 0.3mm - 3mm, preferably 0.4-2mm. The voxel size may be for example e.g. 0,5 to 12mm$^3$, preferably 2 to 8mm$^3$. For a 2D image, the in-plane resolution may for example be 0.3mm - 2mm, preferably 0.4-1.2mm.

The low-resolution scout image preferably covers the same field-of-view as the magnetic resonance image dataset. Thus, in case of a 3D image, it covers the same volume. In case the image dataset is a stack of 2D slices, the scout image comprises also a stack of low-resolution 2D slices. However, it is possible that the low-resolution scout comprises fewer slices than the high-resolution image, for example only every second or third slice. The low-resolution scout image may have a spatial resolution of 2-8mm, preferably 3-5mm, for example 4mm, in the phase-encoding direction(s). Preferably, the acquisition of the scout is very rapid, requiring e.g. 1-5 sec, preferably 1-2 secs. It is preferably acquired once before or after the imaging protocol, preferably before.

Thus, the acquisition of the low-resolution scout is preferably the first method step, though it may also be the last and may, in principle, also be performed in the middle of the imaging protocol. In a further step, the imaging protocol is carried out. Before executing the method of the invention, an MR examination will often comprise some preparatory scans. In particular, SENSE+motion reconstructions require a coil sensitivity map which is typically computed from a separate, very rapid referenced scan. This scan is often the first scan of the acquisition, followed by the low-resolution scout and the imaging scan/protocol. However, this order can be changed as desired.

The sets of additional k-space lines are acquired in a central region of k-space, wherein the central region is preferably covered by the low-resolution scout image. However, each set of additional k-space lines typically comprises fewer k-space lines than would be required to reconstruct a scout image. For example, a set of k-space lines may comprise 1 to 8, preferably 1-4, k-space lines for each 2D slice of a 2D image dataset. In case the image dataset is a 3D image dataset, a set of k-space lines may comprise 2 to 32, preferably 3-8, k-space lines. The set of additional k-space lines is acquired repeatedly during the imaging protocol, namely at - at least approximately - regular intervals. "At least approximately", when used in this application, may mean within ±15%, preferably within ±10%, most preferred within ±5%. Each set of additional k-space lines is intended to provide information on the position of the subject at the point in time at which the set was acquired, also referred to as motion state herein. Therefore, the intervals in which the sets are acquired are preferably set to a time which gives a sufficiently high temporal resolution on the one hand, and on the other hand does not take up too much of the total scan time. The interval at which the sets of additional k-space lines are acquired is preferably between 100ms and 3000ms, more preferred between 5000ms and 1500ms. In 3D imaging protocols, typically one set of guidance lines is acquired per TR, e.g., every 1-3 seconds. In 2D imaging protocols, guidance lines are preferably acquired in every slice, e.g. every 80-250 ms, however, to estimate one motion state, guidance line information from multiple slices needs to combined to obtain through-plane information. Hence, the temporal resolution in 2D may also be in the 1-2sec range.

"Additional" means that the k-space lines are acquired in addition to those that are required under the imaging protocol to acquire the MR image, i.e. they are redundant when it comes to image reconstruction. The sets of additional k-space lines are typically at the same position in k-space at each acquisition, but this is not mandatory.

According to an embodiment, the imaging protocol comprises a plurality of echo trains, one or several k-space lines being acquired in one echo train. An "echo train", also referred to as "shot", comprises a plurality of magnetic resonance (MR) echoes, e.g. spin echoes and/or gradient echoes. During each echo, a k-space line is acquired. In most sequences, an echo train comprises an excitation or preparation pulse, and then all echoes have their own excitation/refocussing pulses. For example, MPRAGE typically has a 180° preparation pulse followed by multiple excitation pulses of around 10°. TSE imaging protocols typically use a 90° excitation pulse followed by multiple 180° refocusing pulse. There may be 1 to 512 echoes, preferably 8 to 256 echoes, in one echo train. In 2D TSE sequences, an echo train may typically contain less than 40, preferably less than 30 echoes. Preferably, one set of additional k-space lines is acquired before or after at least some (e.g. more than 80%) of the echo trains, in particular using low flip angle excitation pulses. There can be as few as one echo per echo train, e.g. in T1-weighted TSE.

According to an embodiment, the low-resolution scout image dataset and the additional k-space lines are acquired after an at least approximately matched magnetization preparation. Thereby, it is possible to also match the contrast at least approximately. Magnetization preparation may in particular mean that, before the excitation pulses, the spins are in a defined spin state, for example they are saturated or inverted. According to this embodiment, the spin state before the acquisition of the scout image and before each set of guidance lines is at least approximately the same. For example, the magnetization preparation may involve a saturation, followed by a defined recovery time or wait time, after which the respective MR data is acquired. The magnetization preparation may be achieved by a specific magnetization preparation module, for example a saturation module, which comprises a saturation RF pulse followed by gradient spoiling. Alternatively, the magnetization preparation may be achieved by the imaging protocol itself. For example, at the end of a TSE echo train, the magnetisation typically is saturated, i.e. the longitudinal magnetisation is negligible. Thus, in order to achieve a matched magnetization preparation, the scout image may be acquired after a saturation preparation module, and the motion guidance lines may be acquired directly after a TSE echo train. Thereby, very similar contrast can be achieved.

According to an embodiment, the low-resolution scout scan and/or the additional k-space lines are acquired using low flip angle excitation pulses. Preferably, they are acquired using a FLASH (Fast Low Angle SHot) type acquisition. FLASH is a gradient echo sequence which combines a low flip angle radio-frequency excitation with a short repetition time. Depending on the desired contrast, the FLASH technique includes spoiled versions, in which coherences in the transverse magnetisation are deliberately destroyed, e.g. using gradient spoilers, and which provide T1-weighted contrast. For providing T2 or T2/T1-weighted contrast, it is possible to incorporate transverse coherences into the steady-state signal by refocussing the magnetisation, either by using a constant phase per repetition, or by using zero phase per repetition, resulting in a fully balanced steady state. Because of its versatility in reaching different kinds of contrast, FLASH is advantageous for acquiring the low-resolution scout and/or the guidance lines. Moreover, the flip angle can be set to such a low value that there is minimal contrast changes of the imaging scan. Any RF excitation (in addition to what is prescribed by the imaging protocol) will change the spin evolution, however, if very small flip angles are selected (e.g. < 5°), the effect will be negligible. According to an embodiment, the low-angle excitation pulses of the low-resolution scout and/or the additional k-space lines have an excitation angle of 1°-30°, more preferred 3°-20°, still more preferred 3°-10°.

In an embodiment, both scout and motion guidance lines are acquired using low flip angle excitation pulses, in particular FLASH. FLASH guidance lines are advantageous because of their versatility and because they can be integrated into any type of imaging protocol. For example, a set of FLASH guidance lines may be acquired after each echo train, in particular TSE echo train.

According to an embodiment, the imaging protocol is a turbo spin-echo sequence, wherein each echo train comprises a plurality of spin echoes, one k-space line being acquired during each spin echo. The turbo factor, i.e. the number of spin echoes per echo train, may be between 2 and 200, preferably 2 to 40. A TSE sequence is advantageous because each TSE echo train, independent of the type of contrast (T1, T2, FLAIR), will lead to the same spin state at the end, namely negligible longitudinal magnetization after the echo train. The imaging protocol may also be a spin-echo sequence having one spin echo per echo train. Preferably, a set of one or several motion guidance lines is acquired a pre-determined recovery time after the last spin echo of some or all of the echo trains, resulting in a T1-weighted contrast of the guidance lines.

According to an embodiment, the low-resolution scout image dataset is acquired using one or several saturation preparation modules, wherein each saturation preparation module is followed by a readout of one or several k-space lines, in particular after a pre-determined recovery time. Thereby, the contrast of the low-resolution scout image dataset can be designed to match that of motion guidance lines, if they are acquired at the end of a TSE echo train, as explained above. The saturation preparation module may comprise a saturation RF pulse, e.g. a 90° pules, followed by a gradient spoiler. After the pre-determined recovery time, the saturation preparation module is followed by an acquisition of several (e.g. 2 to 16, preferably 4 to 8) k-space lines, for example by readouts with low flip angle excitation and spatial encoding gradients.

In an implementation of this embodiment, the additional k-space lines of the low-resolution scout image dataset are acquired a pre-determined first recovery time after a saturation preparation module, and the additional k-space lines are acquired a pre-determined second recovery time after the end of an echo train, preferably a TSE train, which may be followed by a gradient spoiler, wherein the first and second recovery times are equal within ±20%, preferably within ±10%, most preferred within ±5%. Thereby, the contrast of the scout image and the additional k-space lines are matched sufficiently, so that the additional k-space lines can be used in the SAMER motion correction algorithm.

In both the acquisition of the low-resolution scout and the additional k-space lines, spoiler gradients or modules may be used and adapted to suppress undesired coherences in the magnetisation.

According to an embodiment, the imaging protocol is a two-dimensional imaging protocol, in which a stack of two-dimensional slices is acquired. Thus, the MR image dataset comprises a stack of 2D images of slices. In this embodiment, the imaging protocol is preferably a TSE sequence. The invention is particularly advantageous in this embodiment, because the low-resolution scout is also acquired as a set of 2D slices, and this would in the prior art method either considerably lengthen the acquisition time or would lead to mismatched contrast between the scout and the guidance lines. If, however, the motion guidance lines are not acquired as part of the echo train of the imaging protocol - as in the prior art methods, but are for example acquired with a FLASH-type excitation, their contrast can be matched to that of the scout.

2D acquisition provides the further advantage that a slice inter-leaving scheme may be used to best exploit the recovery time (where used) and improve scan efficiency. According to an embodiment, the additional k-space lines relating to one slice are acquired directly after an echo train in which k-space lines of another slice were acquired, in order to increase the second recovery time to the pre-determined value. In other words, the motion guidance lines for one slice are not acquired directly after an echo train from that same slice, but after the echo train from another slice. The order in which the guidance lines are acquired from the different slices is preferably arranged such that each set of guidance lines is acquired a pre-determined second recovery time after the end of an echo train from that slice. For example, one or two echo trains from other slices may be interspersed. Here, it is favourable to choose a slice ordering scheme that reduces overlap/crosstalk between the slices excited during one recovery time, i.e. the slices should not be adjacent.

An alternative way of achieving the desired TI2 time is inserting an additional wait time between the end of an echo train from a specific slice and the acquisition of guidance lines from the same slice.

Also both methods (slice inter-leaving and inserting wait time) can be combined.

A similar acquisition scheme may be applied in the acquisition of the 2D low-resolution scout images: First, the saturation modules may be played for a plurality of slices, and then - after the pre-determined first recovery time for each slice - k-space lines of the plurality of slices are acquired, e.g. using low flip angle excitation. Again, a slice interleaving scheme may be chosen to reduce cross-talk between the slices.

According to an embodiment, the saturation preparation module(s) used in the scout acquisition may include magnetisation transfer (MT) preparation pulses, which are adapted to match the contrast of the low-resolution scout image dataset to the contrast of the additional k-space lines. By such magnetisation transfer pulses, RF energy may be applied exclusively to the pool of bound water. Some of this energy is then transferred to the free water pool. Thereby, the contrast can be tuned to the desired contrast. In particular, the number of MT-pulses per time or their amplitude can be modified to match the contrast of the motion guidance lines. Further, in 2D imaging protocols, the MT preparation pulses may be continued between the slice acquisition of the scout to maintain the desired contrast.

According to an embodiment, in the acquisition of the 2D low-resolution scout image dataset, the saturation preparation module uses a saturation pulse which has a higher slice thickness than the low-angle excitation pulses. Thereby, a more homogenous saturation of the slices can be achieved. Preferably, the slice ordering scheme is adjusted in order to avoid spin history / slice cross talk effects, especially when choosing increased slice thickness for the saturation.

According to an embodiment, in the acquisition of the 2D or 3D low-resolution scout image dataset, the saturation preparation module may use adiabatic RF pulses. Adiabatic pulses are relatively insensitive to B1 inhomogeneity and frequency offset effects, and therefore provide a homogenous saturation of the field-of-view.

According to an embodiment, in the acquisition of the 2D or 3D low-resolution scout image dataset, additional contrast preparation modules may be used in order to match the contrast of the scout to the motion guidance lines. For example, fat suppression or water excitation modules/pulses may be used.

According to an embodiment, flow attenuation pulses applied outside of the field-of-view are used during the acquisition of the low-resolution scout image dataset. Thereby, the signal from inflowing spins is reduced.

According to an embodiment, the imaging protocol includes regional saturation pulses to reduce signal coming from parts of the field-of-view which may be subjected to non-rigid motion during the acquisition of the magnetic resonance imaging dataset. This is especially advantageous for sagittal or coronal slice orientations, e. g. in head imaging, where the field-of-view typically covers body parts which are not of interest. It can also be advantageous to reduce the signal coming from the moving heart when imaging adjacent structures like the lungs.

According to an embodiment, the method includes estimating motion parameters for each set of additional k-space lines directly after they have been acquired, by comparing the respective additional k-space lines with the scout image; and if the motion parameters for a set of k-space lines exceed a pre-determined threshold value, alerting an operator or triggering a re-acquisition of the echo train related to the set of additional k-space lines. The motion parameters may be rigid-body motion parameters, comprising e. g. three translational and three rotational parameters, or non-rigid motion parameters. The motion parameters may be estimated using the first step of the method described below for generating a motion-corrected magnetic resonance image dataset.

According to a further aspect, the invention is also directed to a method for generating a motion-corrected magnetic resonance image dataset of an object, comprising receiving k-space data acquired using the acquisition method according to an embodiment of the invention, and receiving a low-resolution scout image dataset and sets of additional k-space lines acquired using the acquisition method according to an embodiment of the invention.

The motion correction algorithm comprises, in a first step, estimating motion parameters for each set of additional k-space lines by minimizing the data consistency error between the additional k-space lines and a forward model using the low-resolution scout scan as an estimate for the image dataset, wherein the forward model is described by an encoding matrix including the motion parameters to be estimated, Fourier encoding, and optionally subsampling and/or coil sensitivities of a multi-channel coil array. In a second step, the motion correction algorithm comprises estimating the motion-corrected image dataset by minimizing the data consistency error between the k-space data acquired in the imaging protocol and a forward model described by an encoding matrix, wherein the encoding matrix includes the motion parameters estimated in the first step for each set of additional k-space lines, Fourier encoding, and optionally subsampling and/or coil sensitivities of a multi-channel coil array.

The motion parameters may be rigid-body motion parameters, comprising e.g. three translational and three rotational parameters, or non-rigid motion parameters.

Thus, the minimisation problem is carried out in two steps: in a first step, motion parameters are estimated for each set of guidance lines by minimizing the data consistency error of the forward model, which may amount to a comparison with the low-resolution scout image. In a second step, the motion-corrected image is estimated using the motion parameters estimated in the first step. Thereby, alternating repeated updates of the otherwise coupled optimisation variables x (image vector) and $\theta$ (motion parameters) is avoided. Rather, the rapid scout image dataset is used as an image estimate $\tilde{x}$. This leads to a highly efficient optimisation problem that is fully separable across the echo trains and does not require repeated updates of x, which may comprise millions of imaging voxels. The minimisation problem may be derived from a SENSE parallel imaging forward model, as described in K. P. Pruessmann, M. Weiger, M. B. Scheidegger, and P. Boesiger, "SENSE: sensitivity encoding for fast MRI," Magn. Reson. Med., vol. 42, no. 5, pp. 952-962, 1999, with rigid body motion parameters included ("SENSE + motion"). The overall method is described in Magn. Reson. Med. 2023:1-14, doi: 10.1002 / mrm.29534, which is incorporated herein by reference.

In a further aspect of the invention, a magnetic resonance imaging apparatus is provided which comprises a radio frequency controller configured to drive an RF-coil, preferably comprising a multi-channel coil-array, a gradient controller configured to control gradient coils, and a control unit configured to control the radio frequency controller and the gradient controller to execute the imaging protocol according to the invention. The MRI-apparatus may be a commercially available MRI-apparatus which has been programmed to perform the method of the invention.

According to a further aspect of the invention, a computer configured to generate a motion-corrected magnetic resonance image dataset is provided. The computer may be any computer comprising a sufficiently powerful processing unit, which may be a CPU or GPU, or several such processing units. Accordingly, the computer may be a PC, a server, a console of an MRI apparatus, but it also may be a computer that is remote from the MRI apparatus, it may be connected with it through the internet. Accordingly, the computer may also be a cloud computer, a remote server etc. The computer may also be a mobile device, such as a laptop, tablet computer or mobile phone.

According to a further aspect of the invention, a computer program is provided which includes program code, which causes a magnetic resonance imaging apparatus - such as the apparatus described herein - to execute the inventive method, in particular the inventive method for acquiring an MR image dataset. However, the program code may also encode the described method for generating a motion-corrected magnetic resonance image dataset, and the program code may run on a computer as described herein.

According to a further aspect, the invention is directed to a non-transitory computer-readable medium containing a computer program as described herein. The computer-readable medium may be any digital storage medium, such as a hard disc, a cloud, an optical medium such as a CD or DVD, a memory card such as a compact flash, memory stick, a USB-stick, multimedia stick, secure digital memory card (SD) etc.

All features disclosed with regard to the acquisition method may be combined with all features of method for generating a motion-corrected MRI dataset and vice versa. Also, all features of the disclosed methods may be embodied in the MRI apparatus, computer program and computer-readable storage medium according to other aspects of the invention and vice versa.

The accompanying drawings illustrate various example embodiments of various aspects of the invention. In the drawings:

Fig. 1 is a schematic representation of an MRI apparatus according to an embodiment of the invention;

Fig. 2 is a schematic representation of a three-dimensional k-space;

Fig. 3 is a sequence diagram of an MRRAGE sequence with motion guidance lines;

# EP 4 484 992 A1

Fig. 4 is a sequence diagram of a TSE sequence with motion guidance lines;

Fig. 5 is a sequence diagram of a TSE sequence with motion guidance lines according to an embodiment of the invention;

Fig. 6 is a sequence diagram of the scout acquisition according to an embodiment of the invention;

Fig. 7 is an illustration of an alternating optimization algorithm; and

Fig. 8 is an illustration of a SAMER optimization.

Similar elements are designated with the same reference signs in the drawings.

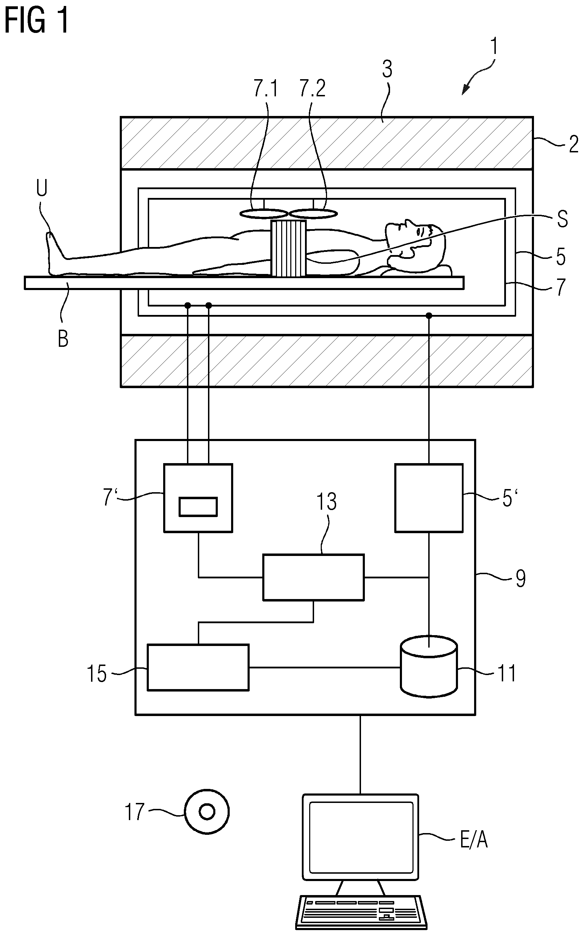

Fig. 1 schematically shows an inventive magnetic resonance (MR) apparatus 1. The MR apparatus 1 has an MR data acquisition scanner 2 with a magnet 3 that generates the constant magnetic field, a gradient coil arrangement 5 that generates the gradient fields, one or several radiofrequency (RF) antennas 7 for radiating and receiving RF signals, and a control computer 9 configured to perform the inventive method. The radio-frequency antennas 7 may include a multi-channel coil array comprising at least two coils, for example the schematically shown coils 7.1 and 7.2, which may be configured to transmit and/or receive RF signals (MR signals).

In order to acquire MR data from an examination subject U, for example a patient or a phantom, the subject U is introduced on a bed B into the measurement volume of the scanner 2. MR data can be acquired using a method according to an embodiment of the invention from a stack S of 2D slices. The control computer 9 controls the MR apparatus 1, and the gradient coil arrangement 5 with a gradient controller 5' and the RF antenna 7 with a RF transmit/receive controller 7'. The RF antenna 7 has multiple channels corresponding to the multiple coils 7.1, 7.2 of the coil arrays, in which signals can be transmitted or received. The control computer 9 also has an imaging protocol processor 15 that determines the imaging protocol, including the sampling order. A control unit 13 of the control computer 9 is configured to execute all the controls and computation operations required for acquisitions. Intermediate results and final results required for this purpose or determined in the process can be stored in a memory 11 of the control computer 9. A user can enter control commands and/or view displayed results, for example image data, an input/output interface E/A. A non-transitory data storage medium 17 can be loaded into the control computer 9 and may be encoded with programming instructions (program code) that cause the control computer 9, and the various functional units thereof described above, to implement any or all embodiments of the method according to the invention.

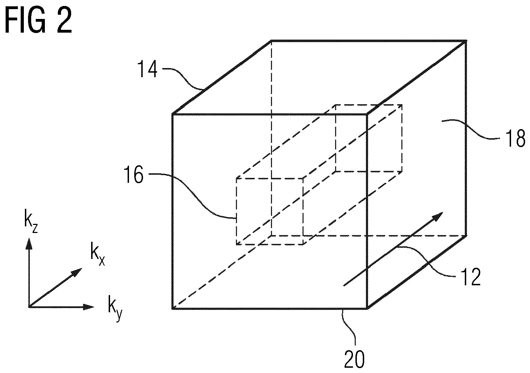

Fig. 2 illustrates a three-dimensional k-space 14 having dimension $k_x$ in frequency encoding (readout) direction, and $k_y$ and $k_z$ in the phase encode plane 20. A k-space line acquired during one echo is illustrated at 12. The k-space volume 14 includes a central region 16 and a periphery 18. The additional k-space lines as well as the k-space lines acquired for the low-resolution scout are located in the central region 16. In the phase encode plane 20, the central region 16 may cover about 1/12 to 1/16 in each direction, i.e. less than 1/100 of the total square phase encode plane 20.

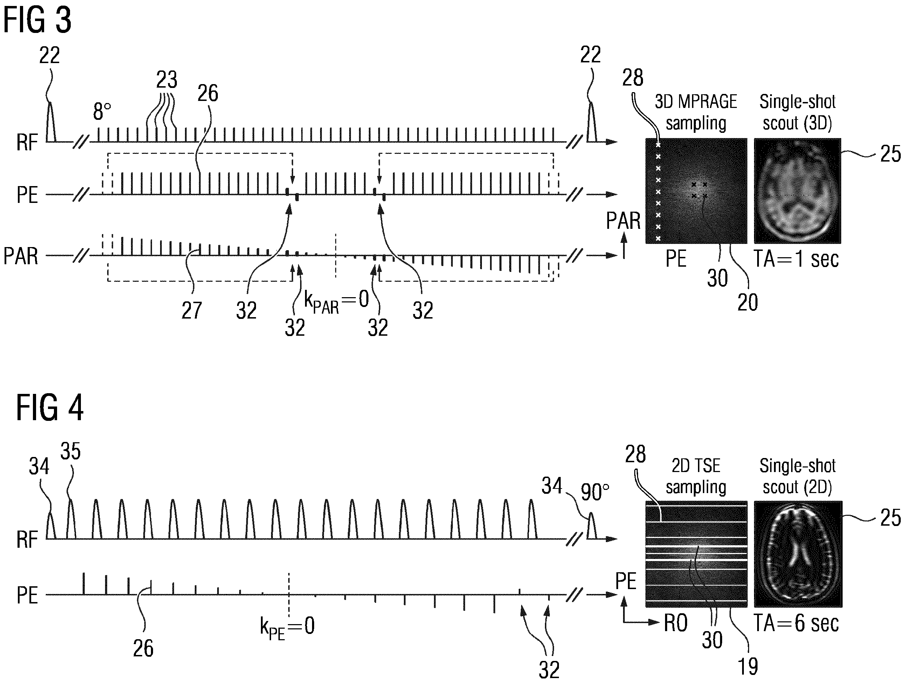

Fig. 3 illustrates a 3D MPRAGE sequence with motion guidance lines according to the prior art disclosed in Magn. Reson. Med 2023:1-14, doi: 10.1002/mrm.29534. On the left, a sequence diagram is shown indicating the RF pulses on the top, the phase encode (PE) gradients in the first direction in the middle, and the phase encode gradients in the second direction (PAR for partition) at the bottom. As usual for MPRAGE, an echo train starts with a 180° inversion pulse 22, followed by a wait time and then by a series of low flip angle (here 8°) pulses 23, wherein a k-space line is acquired after each pulse 23. The ordering is linear, wherein after each readout, phase encode gradient blips 26, 27 are applied in the PE and PAR directions, so that the phase encode plane 20 is sampled in a straight line, as illustrated at 28, wherein each point 28 indicates a k-space lines oriented perpendicular to the phase encode plane 20. Four echoes from the regular imaging protocol were removed from the echo train to accommodate four guidance lines 30 located near the centre of k-space. The respective phase encode gradients are illustrated at 32. The corresponding 3D MPRAGE low-resolution scout image 25 is acquired in a single shot, which requires only an acquisition time TA of about 1 sec. If linear sampling is used, its contrast - in this particular case - matches the contrast of the guidance lines, because the centre of k-space is sampled at about the same wait time after the inversion pulse 22 for both the scout image and in the high-resolution image. However, this approach - exchanging some of the k-space lines from the regular imaging protocol with the guidance lines and sampling the scout image with the same type of imaging sequence - will not work for all types of imaging sequence and contrasts, as demonstrated by the next example.

Fig. 4 illustrates a T2-weighted 2D TSE sequence with motion guidance lines according to the prior art. The depicted echo train comprises a 90° pulse 34 followed by a train of 180° refocussing pulses 35, which result in a train of spin-echoes. Since it is a 2D sequence, only one phase encoding gradient PE is applied, and the depicted 3D k-space 19 has PE and RO (readout) dimensions, so that one k-space line 28 is depicted not as a point, but as a line in this illustration 19. In this imaging protocol, standard distributed ordering is used, and two guidance lines 30, 32 are appended at the end of each echo train. The single-shot scout scan 25 (TA = 6 sec) matches the contrast of the guidance lines, here heavily T2-weighted due to a long TE of approximately 200 ms. However, the acquisition time of 6 seconds is rather long, hence the scout cannot be considered motion-free which is prerequisite for SAMER. This is an example where it is not advantageous to integrate the motion guidance lines into the echo train, and use the same type of imaging sequence for the scout and the high-resolution image dataset.

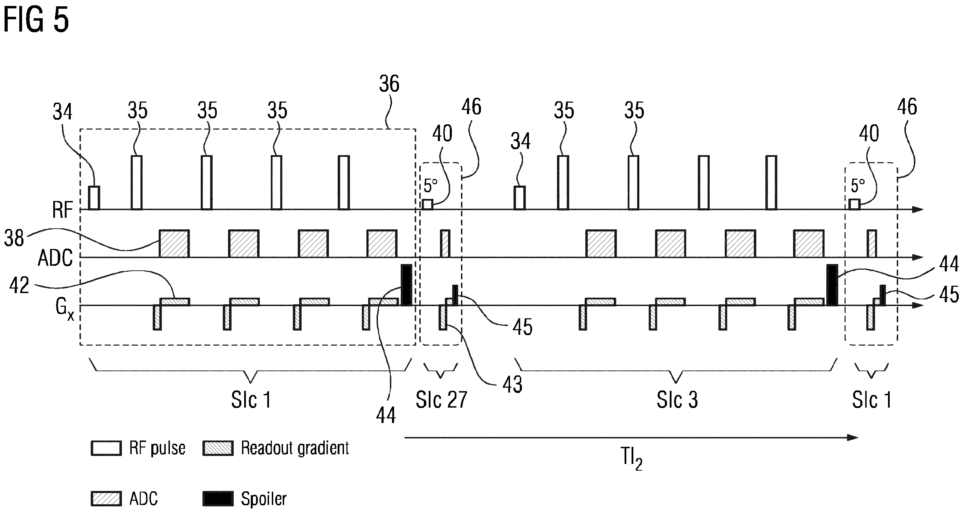

Fig. 5 illustrates a 2D TSE sequence according to an embodiment of the invention. In particular, it demonstrates the implementation of FLASH guidance lines into a 2D TSE sequence, wherein a set of one (or multiple) flash guidance lines 46 are inserted after each TSE echo train 36. The sequence diagram depicts the RF pulses on the top, the readout windows 38 indicated as ADC (analogue-to-digital converter), and the readout gradient $G_x$ on the bottom line. Note that two echo trains 36 are illustrated for different slices of the stack of 2D slices, the first for slice no. 1 and the second for slice no. 3. The RF pulses of each echo train 36 include a 90° pulse 34 followed by a train of 180° refocussing pulses 35. After each refocussing pulse 35, a k-space line is acquired during readout 38, using readout (frequency encoding) gradient 42.

After each TSE echo train 36, a gradient spoiler 44 is played in order to destroy and unwanted coherences. After the gradient spoiler 44, the second recovery time $TI_2$ begins and after it has elapsed, a set 46 of one or multiple guidance lines 30 are played on the same slice, each comprising a low-flip angle slice selective excitation pulse 40, spatial encoding gradients 43 and a gradient spoiler 45. In contrast to the prior art 2D TSE sequence illustrated in Fig. 4, the guidance lines are no longer part of the TSE echo train 36 but present a separate entity 46. A small RF flip angle (e.g., 5°) is used in the pulses 40 to minimize impact on the TSE imaging contrast. Moreover, the slice ordering of the guidance lines is permuted, e.g., the TSE echo train for slice no. 1 is followed by a set 46 of one or several guidance line for slice no. 27, and the TSE echo train for slice no. 3 is followed by a guidance line for slice no. 1. This permutation allows to use the recovery time $TI_2$ and thereby boosts the available signal in the guidance lines. In the example shown in Fig. 3, guidance lines for a specific slice are acquired a recovery time $TI_2$ after the corresponding TSE echo train, wherein $TI_2$ can be about 150-400ms, preferably 200-350ms, more preferred 240-290ms, for example about 300ms. In case of short TSE echo trains, the guidance lines for a given slice can be acquired N echo trains later, in order to achieve a beneficial $TI_2$. Optionally, guidance lines are not acquired for every slice, but only a subset, if the temporal resolution is high enough. Besides T1 recovery, also magnetization transfer effects occur during $TI_2$. In this example, the acquisition and contrast of the motion guidance lines is completely decoupled from those of the imaging protocol, and the type of imaging sequences and sequence settings with which they are acquired is different (FLASH vs. TSE).

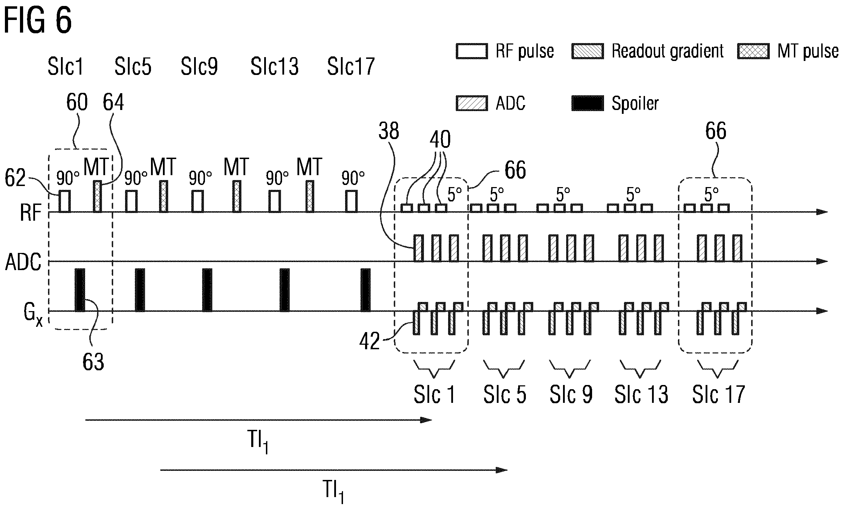

Fig. 6 demonstrates an example implementation of a low-resolution scout acquisition which is designed to match the contrast of the flash guidance lines used in the 2D TSE sequence illustrated in Fig. 5. The scout acquisition consists of saturation modules 60 for slice numbers 1, 5, 9, 13, 17, each saturation module 60 comprising a 90° RF pulse 62 followed by gradient spoiling 63, a recovery time $TI_1$ and a readout module 66. However, one can also envision more complicated saturation techniques including multiple RF pulses and spoilers including flip angles deviating from 90°. The readout module 66 includes a small number (e. g. 2 to 18, preferably 4 to 8) of FLASH-type readouts including low-flip angle slice selective excitations 40, spatial encoding gradients and spoiling (not shown). Spoiling is preferably used both for the flash guidance lines in the scout and the imaging protocol. The readout modules 66 of each slice are played a pre-determined first recovery time $TI_1$ after the saturation module 60 of the respective slice. A slice inter-leaving scheme is used to best exploit the recovery time $TI_1$ and improve scan efficiency - in this case, first the saturation modules 60 for the 1st, 5th, 9th 13th and 17th slice are played consecutively, followed by readout modules 66 for the 1st, 5th, 9th 13th and 17th slice. It is favourable to choose a slice ordering scheme that reduces overlap/crosstalk between the slices excited during one TI.

It is highly advantageous to match the second recovery time $TI_2$ of the guidance lines (see Fig. 5) to the first recovery times $TI_1$ of the scout (Fig. 6), as otherwise their contrast will differ. In this example, the recovery time $TI_1$ is also at least approximately 300ms.

Additionally, magnetization transfer pulses MT can be included to better match the contrast of the flash guidance lines.

The proposed scout and guidance lines approach is independent of the desired TSE imaging contrast, i.e., the same acquisition module can be used across e.g. T1, T2 and FLAIR TSE. This is because each TSE echo train (T1, T2, FLAIR) will lead to the same spin state (negligible longitudinal magnetization) which we can also produce in the scout using a saturation module. Moreover, the FLASH guidance lines were designed to cause minimal disruption to the TSE sequence timing, which makes them easy to integrate. The scout acquisition is very rapid (1-2 sec) and can be played once before the imaging sequence. The data consistency-based motion estimation using the scout and guidance lines follows the approach disclosed in the articles by D. Polak et al. in Magn. Reason. cited herein. In vivo example reconstructions with instructed step motion have shown a significant improvement in image quality after retrospective motion correction.

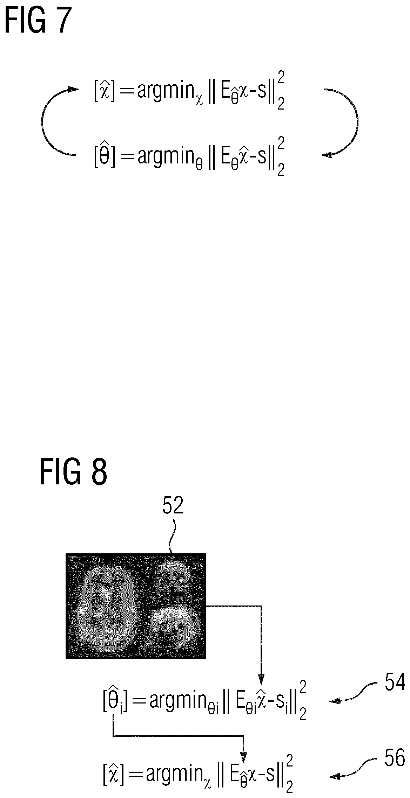

A retrospective motion correction technique which may be used on the MR signals acquired with the inventive acquisition method, and especially to estimate the motion states, will now be described with reference to Fig. 7 and 8. The mathematical model used is an extension of SENSE parallel imaging, as described in the above-cited paper by K. P. Pruessmann et al., with rigid-body motion parameters included into the forward model. The forward model or encoding operator $E_\theta$ for a given patient motion vector $\theta$ (comprising motion parameters over time) relates the motion-free image $x$ to the acquired multi-channel k-space data $s.$ At each time point $i$ that is considered, e.g. the acquisition time of the sets of guidance lines, the subject's position is described by a new set of six rigid-body motion parameters $\theta_i$ that describe the 3D position of the object. Accordingly, the multi-channel k-space data $s_i$ acquired at time point $i$ may be related to the 3D image volume $x$ through image rotations $R_i$, image translations $T_i$, coil sensitivity maps $C$, Fourier operator $F$ and undersampling mask $M_i$ by the following formula 1

$$s_i = E_{\theta_i} x = M_i\, F\, C\, T_{\theta_i} R_{\theta_i} x \qquad [1]$$

In prior art methods, as illustrated in Fig. 7, both the motion corrected image vector $x$ and the motion vector (trajectory) $\theta$ are estimated by performing an alternating, repeated optimization between the image vector (formula 2) and the motion vector (formula 3):

$$[\widehat{x}] = \mathrm{argmin}_x \|E_{\widehat{\theta}} x - s\|_2 \qquad [2]$$

$$[\widehat{\theta}] = \mathrm{argmin}_\theta \|E_\theta \widehat{x} - s\|_2 \qquad [3]$$

This can lead to convergence issues as updates of $x$ and $\theta$ will be computed on inaccurate information. Moreover, the reconstruction is computationally demanding as repeated updates of $x$ (millions of imaging voxels) are needed.

Using one or several ultra-fast low-resolution scout scans 52, the motion trajectory may be directly estimated, as illustrated in Fig. 8, thus avoiding the time-consuming alternate optimization. The scout image 52, designated by $\widetilde{x}$, approximates the motion-free image volume $\widehat{x}$ and each motion state can be determined independently by minimizing the data consistency error of the forward model 54:

$$[\widehat{\theta}_i] = \mathrm{argmin}_{\theta_i} \|E_{\theta_i} \widetilde{x} - s_i\|_2 \qquad [4]$$

In the method of the invention, the guidance lines are used instead of or in addition to the k-space data $s$ in this first step of the optimization. Preferably, only the guidance lines are used.

For the final image reconstruction, the motion states/parameters from each set of guidance lines are combined and the motion-mitigated image is obtained from solving a standard least-squares problem 56:

$$[\widehat{x}] = \mathrm{argmin}_x \|E_{\widehat{\theta}} x - s\|_2 \qquad [5]$$

This strategy completely avoids the difficult non-linear and non-convex joint optimization that contains millions of unknowns, as it only considers six rigid body parameters per motion optimization, and it does not require computationally costly full or partial updates to the image.

**Claims**

1. A method for acquiring a magnetic resonance image dataset of a field-of-view including a body part of a subject (U),

   using an imaging protocol in which spatial encoding is performed using phase encoding gradients along at least one phase encoding direction (PE, PAR), and frequency encoding gradients along a frequency encoding direction ($G_x$), wherein k-space (14, 19) is sampled during the imaging protocol in a plurality of k-space lines (12) oriented along the frequency encoding direction, and having different positions in the at least one phase encoding direction ($G_y$),
   wherein the method comprises acquiring a low-resolution scout image dataset (25, 52) of the field-of-view, and wherein the method comprises acquiring sets of one or several additional k-space lines (30) within a central region (16) of k-space at - at least approximately - regular intervals during the imaging protocol,
   **characterised in that** the contrast of the low-resolution scout image dataset (25) and the contrast of the additional k-space lines (30) are at least approximately matched and are in particular independent of the contrast of the magnetic resonance image dataset.

2. The method of claim 1, **characterised in that** the low-resolution scout image dataset (25) and the additional k-space lines (30) are acquired after an at least approximately matched magnetization preparation (60).

3. The method of claim 1 or 2, wherein the low-resolution scout scan (25) and the additional k-space lines (30) are acquired using low flip angle excitation pulses (40).

4. The method of one of the preceding claims, **characterised in that** the low-resolution scout image dataset (25) is acquired using one or several saturation preparation modules (60), which are designed such that the contrast of the low-resolution scout image dataset (25) matches that of the additional k-space lines (30), wherein each saturation preparation module (60) is followed by a readout of one or several k-space lines, in particular after a pre-determined first recovery time ($TI_1$).

5. The method of one of the preceding claims, **characterised in that** the imaging protocol comprises a plurality of echo trains (36), one or several k-space lines (28) being acquired in each echo train, wherein a set of additional k-space lines (30) is acquired before or after at least some of the echo trains (36), in particular using low flip angle excitation pulses (40).

6. The method of any one of the preceding claims, **characterised in that** the k-space lines of the low-resolution scout image dataset (25) are acquired a pre-determined first recovery time ($TI_1$) after a saturation preparation module (60), and **in that** the additional k-space lines (30) are acquired a pre-determined second recovery time ($TI_2$) after an echo train (36), wherein the first and second recovery times are equal within $\pm 20\%$, preferably within $\pm 10\%$, most preferred within $\pm 5\%$.

7. The method of any one of the preceding claims, **characterised in that** the imaging protocol is a two-dimensional imaging protocol, in which a stack (S) of two-dimensional slices is acquired.

8. The method of claim 7,

   **characterised in that** the additional k-space lines (30) relating to one slice are acquired directly after an echo train (36) in which k-space lines of another slice were acquired, in order to increase the second recovery time to the pre-determined value, and/or
   **in that** the low-resolution scout image dataset (25) is acquired by first playing the saturation preparation modules (60) relating to a plurality of slices, and then acquiring k-space lines of the plurality of slices after the pre-determined first recovery time ($TI_1$).

9. The method of any one of the preceding claims, **characterised in that** the saturation preparation module(s) (60) include magnetisation transfer preparation pulses (MT), which are adapted to match the contrast of the low-resolution scout image dataset (25) to the contrast of the additional k-space lines (30).

10. The method of any one of the preceding claims, **characterised in that** flow attenuation pulses applied outside of the field-of-view are used during the acquisition of the low-resolution scout image dataset (25).

11. The method of any one of the preceding claims, **characterised in that** the imaging protocol includes regional saturation pulses to reduce signal coming from parts of the field-of-view which may be subjected to non-rigid motion during the acquisition of the magnetic resonance imaging dataset.

12. The method of any one of the preceding claims, **characterised in that** the method includes estimating motion parameters ($\theta_i$) for each set of additional k-space lines (30) directly after they have been acquired, by comparing the respective additional k-space lines (30) (12) with the scout image (52); and
   if the motion parameters for a set of k-space lines exceed a pre-determined threshold value, alerting an operator or triggering a re-acquisition of the echo train related to the set of additional k-space lines (30).

13. A method for generating a motion-corrected magnetic resonance image dataset of an object, comprising:

   receiving k-space data (14) acquired using the acquisition method according to any one of claims 1 to 12,
   receiving a low-resolution scout image dataset (25) and sets of additional k-space lines (30) acquired using the acquisition method according to any one of claims 1 to 12;
   in a first step, estimating motion parameters ($\theta_i$) for each set of additional k-space lines (30) by minimizing the data consistency error between the additional k-space lines (30) and a forward model using the low-resolution scout scan as an estimate for the image dataset, wherein the forward model is described by an encoding matrix including the motion parameters ($\theta_i$) to be estimated, Fourier encoding (F), and optionally subsampling (M) and/or coil sensitivities (C) of a multi-channel coil array (7.1, 7.2); and
in a second step, estimating the motion-corrected image dataset (x) by minimizing the data consistency error between the k-space data (14) acquired in the imaging protocol and a forward model described by an encoding matrix, wherein the encoding matrix includes the motion parameters $(\theta_i)$ estimated in the first step for each set of additional k-space lines (30), Fourier encoding (F), and optionally subsampling (M) and/or coil sensitivities (C) of a multi-channel coil array (7.1, 7.2).

14. A magnetic resonance imaging apparatus (1) configured to execute the method of one of the preceding claims, comprising:

a radio frequency controller (7') configured to drive an RF-coil (7) comprising a multi-channel coil array (7.1, 7.2),
a gradient controller (5') configured to control gradient coils (5),
a control unit (13) configured to control the radio frequency controller (7') and the gradient controller (5') to execute the imaging protocol.

15. A computer program including program code, which causes a magnetic resonance imaging apparatus (1) to execute the method according to any one of claims 1 to 13.

FIG 1

FIG 2

FIG 3

FIG 4

EP 4 484 992 A1

FIG 5

Slc 1    Slc 27    Slc 3    Slc 1

$TI_2$

RF

ADC

$G_x$

5°   5°

RF pulse    Readout gradient

ADC    Spoiler

34, 35, 36, 38, 40, 42, 43, 44, 45, 46

FIG 6

# FIG 7

$$[\hat{\chi}] = \mathrm{argmin}_{\chi} \, \| E_{\hat{\theta}}\chi - s \|_2^2$$

$$[\hat{\theta}] = \mathrm{argmin}_{\theta} \, \| E_{\theta}\hat{\chi} - s \|_2^2$$

# FIG 8

52

$$[\hat{\theta}_i] = \mathrm{argmin}_{\theta i} \, \| E_{\theta i}\hat{\chi} - s_i \|_2^2 \quad \text{—}\; 54$$

$$[\hat{\chi}] = \mathrm{argmin}_{\chi} \, \| E_{\hat{\theta}}\chi - s \|_2^2 \quad \text{—}\; 56$$

Europäisches
Patentamt

European
Patent Office

Office européen
des brevets

# EUROPEAN SEARCH REPORT

Application Number

EP 23 18 2026

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | POLAK DANIEL ET AL: "Motion guidance lines for robust data consistency-based retrospective motion correction in 2D and 3D MRI", MAGNETIC RESONANCE IN MEDICINE, vol. 89, no. 5, 6 February 2023 (2023-02-06), pages 1777-1790, XP093047025, US ISSN: 0740-3194, DOI: 10.1002/mrm.29534 Retrieved from the Internet: URL:https://onlinelibrary.wiley.com/doi/full-xml/10.1002/mrm.29534> * the whole document * | 1-15 | INV. G01R33/48 G01R33/561 G01R33/565 |
| A | POLAK DANIEL ET AL: "Scout accelerated motion estimation and reduction (SAMER)", MAGNETIC RESONANCE IN MEDICINE, WILEY-LISS, US, vol. 87, no. 1, 1 January 2021 (2021-01-01), pages 163-178, XP002806334, ISSN: 0740-3194, DOI: 10.1002/MRM.28971 * the whole document * | 1-15 | |
| A | WRIGHT S M ET AL: "A multi-plane scout sequence using flash imaging", MAGNETIC RESONANCE IMAGING, ELSEVIER SCIENCE, TARRYTOWN, NY, US, vol. 6, no. 2, 1 March 1988 (1988-03-01), pages 105-112, XP026307710, ISSN: 0730-725X, DOI: 10.1016/0730-725X(88)90439-0 [retrieved on 1988-03-01] * the whole document * | 1-15 | |

TECHNICAL FIELDS
SEARCHED     (IPC)

G01R

The present search report has been drawn up for all claims

| Place of search | Date of completion of the search | Examiner |
|---|---|---|
| Munich | 1 December 2023 | Vanhaecke, Nicolas |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **J. HAMILTON** ; **D. FRANSON** ; **N. SEIBERLICH**. Recent Advances in Parallel Imaging for MRI,. *Prog. Nucl. Magn. Reson. Spectrosc.*, 2017, vol. 101, 71-95
- **L. CORDERO-GRANDE** ; **E. J. HUGHES** ; **J. HUTTER** ; **A. N. PRICE** ; **J. V HAJNAL**. Three-dimensional motion corrected sensitivity encoding reconstruction for multi-shot multi-slice MRI: Application to neonatal brain imaging,. *Magn. Reson. Med.*, 2018, vol. 79 (3), 1365-1376
- **L. CORDERO-GRANDE** ; **R. TEIXEIRA** ; **E. HUGHES** ; **J. HUTTER** ; **A. PRICE** ; **HAJNAL**. Sensitivity Encoding for Aligned Multishot Magnetic Resonance Reconstruction,. *IEEE Trans. Comput. Imaging*, 2016, vol. 2 (3), 266-280
- **M. W. HASKELL** ; **S. F. CAULEY** ; **L. L. WALD**. TArgeted Motion Estimation and Reduction (TAMER): Data consistency based motion mitigation for MRI using a reduced model joint optimization,. *IEEE Trans. Med. Imaging*, 2018, vol. 37 (5), 1253-1265
- **L. CORDERO-GRANDE**. *Magn. Reson. Med.*
- **D. POLAK** ; **D. N. SPLITTHOFF** ; **B. CLIFFORD** ; **W.-C. LO** ; **S. HUANG** ; **J. CONKLIN** ; **L. L. WALD** ; **K. SETSOMPOP** ; **S. CAULEY**. Scout accelerated motion estimation and reduction (SAMER). *Magn. Reson. Med.*, 2022, vol. 87, 163-178, https://doi.org/10.1002/mrm.28971
- **D. POLAK** ; **J. HOSSBACH** ; **D. N. SPLITTHOFF et al.** Motion guidance lines for robust data consistency-based retrospective motion correction in 2D and 3D MRI. *Magn. Reson. Med.*, 2023, 1-14
- **D. POLAK**. *Magn. Reson. Med.*, 2023, 1-14
- **D. POLAK et al.** *Magn. Reson. Med.*, 2022, vol. 87, 163-178
- *Magn. Reson. Med.*, 2023, 1-14
- **K. P. PRUESSMANN** ; **M. WEIGER** ; **M. B. SCHEIDEGGER** ; **P. BOESIGER**. SENSE: sensitivity encoding for fast MRI. *Magn. Reson. Med.*, 1999, vol. 42 (5), 952-962
- *Magn. Reson. Med*, 2023, 1-14